# EUROPÄISCHE PATENTANMELDUNG

(11) **EP 3 923 346 A1**
(43) Veröffentlichungstag der Anmeldung: **15.12.2021**
(21) Anmeldenummer: 21173797.8
(22) Anmeldetag: 14.05.2021
(51) Int. Cl.: H01L 29/423, H01L 21/04, H01L 29/78, H01L 21/336

(54) **VERFAHREN ZUR HERSTELLUNG EINES TRENCH-MOSFET**

(30) Priorität: 08.06.2020 DE 102020115157
(71) Anmelder: Fraunhofer-Gesellschaft zur Förderung der angewandten Forschung e.V., 80686 München (DE)
(72) Erfinder: Lim, Minwho, 91058 Erlangen (DE); Rusch, Oleg, 91058 Erlangen (DE); Erlbacher, Dr. Tobias, 91058 Erlangen (DE); Sledziewski, Dr. Tomasz, 91058 Erlangen (DE); Schlichting, Holger, 91058 Erlangen (DE)
(74) Vertreter: Gagel, Roland

(57) **Zusammenfassung**

Bei einem Verfahren zur Herstellung eines Trench-MOSFET werden Gräben (3) in einer monokristallinen Halbleiterschicht (2) erzeugt und die Oberfläche dann zunächst ganzflächig mit einer Streuoxid-Schicht (5) und anschließend mit einer Polysiliziumschicht bedeckt, so dass die Gräben (3) zumindest teilweise mit dem Polysilizium (6) aufgefüllt sind. Die Polysiliziumschicht wird dann bis auf Oberflächen der Halbleiterschicht in den Bereichen zwischen den Gräben (3) planarisiert. Durch eine thermische Oxidation von freiliegenden Oberflächen des Polysiliziums (6) in den Gräben (3) wird eine dicke SiO₂-Schicht (7) über dem Polysilizium (6) erzeugt, die als Implantationsmaske für nachfolgende Implantationsschritte dient. Anschließend erfolgen die Ionenimplantationsschritte zur Erzeugung der Source- und Wannen-Gebiete (9, 10) sowie die weiteren Schritte zur Fertigstellung des MOSFET. Das Verfahren ermöglicht die Herstellung von Trench-MOSFETs in SiC ohne das Erfordernis einer Lithographieanlage für die Erzeugung der Source- und Wannen-Gebiete in kostengünstiger Weise.

## Beschreibung

### Technisches Anwendungsgebiet

Die vorliegende Erfindung betrifft ein Verfahren zur Herstellung eines Trench-MOSFET, bei dem vor einer Ionenimplantation zur Erzeugung von Source-Gebieten und Wannen-Gebieten Gräben in einer monokristallinen Halbleiterschicht erzeugt und zumindest teilweise mit Polysilizium aufgefüllt werden.

Trench-MOSFETs (MOSFET: Metal-Oxide-Semiconductor Field-Effect Transistor) sind vertikal aufgebaute Transistorbauelemente, bei denen der Transistorkanal vertikal verläuft. Trench-MOSFETs haben gegenüber planaren MOSFETs den Vorteil, dass die bei planaren MOSFETs vorhandene JFET-Region und der damit verbundene elektrische Widerstand entfallen. Sie weisen daher einen geringeren Widerstand auf und ermöglichen aufgrund ihrer größeren Integrationsdichte eine Einsparung an Chipfläche und damit auch Herstellungskosten.

### Stand der Technik

Bei der Herstellung von Trench-MOSFETs werden bisher häufig Lithographiemasken eingesetzt, mit denen alle in das Bauelement zu übertragenden Strukturen durch entsprechend lichtdurchlässige und lichtundurchlässige Bereiche definiert sind. Für eine maskenkonforme Strukturübertragung sind Lithographiemasken mit entsprechend hohem Auflösungs- und Justiervermögen notwendig, wobei auch hier technologiebedingte Limitationen nicht unterschritten werden können. Dies führt zu entsprechend hohen Kosten. Zur Vermeidung derartiger Lithographiemasken bei der Erzeugung der Source-Bereiche und der Wannen-Bereiche durch Ionenimplantation sind selbstjustierende Herstellungsprozesse bekannt.

Der Stand der Technik zu selbstjustierenden Herstellungsprozessen von Trench-MOSFETs in Silizium (Si) ist die Erzeugung von selbstjustierten n⁺-Sourcekontakten bzw. p-Wanne-Gebieten nach erfolgter Erzeugung der Grabenstruktur, auch als "Trench-First" bezeichnet. Die US 9735266 B2 zeigt ein Beispiel für diese Herstellungstechnik. Hierbei werden zunächst die Gräben bis zu einer Tiefe von 40 µm in die monokristalline Siliziumschicht geätzt und anschließend ein dünnes Oxid thermisch aufgewachsen. Im Anschluss daran wird eine Polysiliziumschicht abgeschieden, um die Gräben zumindest teilweise mit Polysilizium aufzufüllen. Das zwischen den Gräben vorhandene Polysilizium wird durch Trockenätzen entfernt. Anschließend wird ganzflächig eine dünne Oxidschicht abgeschieden und an den Grabenwänden mittels eines Nassätz-Prozesses (BOE: Buffered-Oxide-Etch) entfernt. Nach dem lokalen isotropen Ätzen der Siliziumschicht bis an die Oberfläche des Polysiliziums erfolgt die selbstjustierende n⁺-Source und p-Wanne-Implantation. Diese Technik ist für die Erzeugung von Trench-MOSFETs in Silizium geeignet, lässt sich jedoch aufgrund der unterschiedlichen Materialeigenschaften nicht identisch auf Siliziumcarbid (SiC) übertragen.

Daher wird für die Herstellung von Trench-MOSFETs in monokristallinen Schichten aus Siliziumcarbid bisher eine andere selbstjustierende Herstellungstechnik eingesetzt, bei der die Erzeugung der Grabenstruktur nach erfolgter Ionenimplantation erfolgt ("Trench-Last"). Ein Beispiel für diese Herstellungstechnik ist in der US 5614749 A beschrieben. Grundsätzlich werden hierbei die n⁺-Source und p-Wanne-Gebiete zunächst ganzflächig in den aktiven Bereich der SiC-Schicht implantiert. Die Gräben werden dann erst anschließend in diese implantierten Gebiete geätzt. Die Steuerung des Ätzprozesses ist hierbei jedoch schwierig, da der Ätzprozess von der Dotierung der Bereiche abhängt.

Die US 2008/0081422 A1 beschreibt ein Verfahren zur Herstellung eines Trench-MOSFET, bei dem in einer monokristallinen Halbleiterschicht Gräben erzeugt werden, in die eine Streuoxid-Schicht und eine Polysiliziumschicht abgeschieden werden. Die Polysiliziumschicht wird bis auf Oberflächen der Halbleiterschicht zwischen den Gräben planarisiert und eine thermische SiO2-Schicht über dem Polysilizium in den Gräben erzeugt. Die SiO2-Schicht bildet eine Implantationsmaske für nachfolgende Implantationsschritte, bei denen Source-Gebiete eines ersten Dotierungstyps und Wannen-Gebiete eines zweiten Dotierungstyps erzeugt werden. Eine ähnliche Vorgehensweise ist auch in der US 2010/0032751 A1 offenbart.

Die Aufgabe der vorliegenden Erfindung besteht darin, ein Verfahren zur Herstellung eines Trench-MOSFET anzugeben, das sich für die Herstellung von Trench-MOSFETs in monokristallinen SiC-Schichten eignet, ohne Lithographiemasken für die Erzeugung der Source- und Wannen-Gebiete auskommt und die Herstellung einer gleichmäßigen Grabenstruktur ermöglicht.

### Darstellung der Erfindung

Die Aufgabe wird mit dem Verfahren gemäß Patentanspruch 1 gelöst. Vorteilhafte Ausgestaltungen des Verfahrens sind Gegenstand der abhängigen Patentansprüche oder lassen sich der nachfolgenden Beschreibung sowie dem Ausführungsbeispiel entnehmen. Bei dem vorgeschlagenen Verfahren werden zunächst die Gräben in einer monokristallinen, insbesondere epitaktischen, Halbleiterschicht durch einen geeigneten Ätzprozess erzeugt. Anschließend wird eine Streuoxid-Schicht, vorzugsweise ganzflächig, und anschließend eine Polysiliziumschicht abgeschieden, so dass die Gräben zumindest teilweise mit Polysilizium aufgefüllt sind. Die Polysiliziumschicht wird dann bis auf Oberflächen der Halbleiterschicht zwischen den Gräben planarisiert, vorzugsweise durch Trockenätzen. Das Verfahren zeichnet sich dadurch aus, dass vor den Implantationsschritten zur Erzeugung der Source- und Wannen-Bereiche, insbesondere n⁺-Source und p-Wanne, durch thermische Oxidation der freiliegenden Oberflächen des Polysiliziums eine ausreichend dicke SiO₂-Schicht über dem Polysilizium in den Gräben erzeugt wird, die als Implantationsmaske für die nachfolgenden Implantationsschritte dient und die Gefahr leitfähiger Kanäle an den Seitenwänden der Gräben verhindert, die sich ansonsten als Folge einer nicht perfekt planarisierten Polysiliziumoberfläche bilden könnten. Über die Dicke dieser thermischen Oxidschicht kann auch die Dotierung im Transistorkanal und damit die Schwellspannung und die Kanallänge beeinflusst werden. Die Dicke der thermischen Oxidschicht kann über die Oxidationszeit und die Temperatur bei der Oxidation gesteuert werden. Die thermische Oxidation des Polysiliziums kann dabei so lange durchgeführt werden, bis das Niveau der Oberfläche der thermischen Oxidschicht das Niveau der Oberfläche der Halbleiterschicht zwischen Gräben (MESA-Struktur) erreicht. Häufig - aber nicht in jedem Fall - wird die thermische Oxidschicht mit einer Dicke > 100 nm erzeugt.

Das vorgeschlagene Herstellungsverfahren kommt ohne Lithographieschritte zur Erzeugung der Source- und Wannen-Gebiete des Bauelementes aus und ist somit unabhängig vom Auflösungs- und Justiervermögen einer Lithographieanlage. Durch die zuverlässige Implantationsmaskierung mittels oxidiertem Polysilizium in den Gräben (thermische Oxidschicht) werden die durchgehenden, unmittelbar bis an den Rand des Grabens grenzenden Source- und Wannen-Gebiete so realisiert, dass das Risiko eines sich ausbildenden leitfähigen Kanals an den Grabenseitenwänden eliminiert wird. Bei dem vorgeschlagenen Verfahren lässt sich auch die Dotierung im Kanalbereich des Transistors durch die Wahl der thermischen Oxiddicke über dem Polysilizium einstellen. Dies beeinflusst die Einsatzspannung und die Kanallänge als wesentliche Faktoren des Kanalwiderstands. Gleichzeitig ergibt sich im Vergleich zu einem "Trench-Last"-Prozess bei diesem Vorgehen keine Reduzierung der Spannungsfestigkeit der Bauelementstrukturen. Bei letzterem ist die Dimensionierung der Wannen-Dotierung hin zu niedrigen Dotierstoffkonzentrationen eingeschränkt.

In einer vorteilhaften Ausgestaltung des vorgeschlagenen Verfahrens erfolgt nach der thermischen Oxidation zur Erzeugung der ausreichend dicken thermischen SiO₂- bzw. Oxidschicht über dem Polysilizium in den Gräben eine ganzflächige Abscheidung einer dünnen Streuoxid-Schicht, da die anfänglich abgeschiedene dünne Streuoxid-Schicht möglicherweise bei der Planarisierung des Polysiliziums an manchen Stellen entfernt wurde.

Nach der Erzeugung der Source- und Wannen-Gebiete des ersten und zweiten Dotierungstyps wird das Polysilizium mit der darüber liegenden thermischen Oxidschicht aus den Gräben entfernt. Anschließend können p⁺-Gebiete über einen Maskierungsprozess durch Ionenimplantation erzeugt werden, die als Abschirmung dienen. In die Gräben wird dann eine Gate-Oxidschicht und wiederum eine Polysiliziumschicht abgeschieden und planarisiert. Als nachfolgender Schritt wird eine geeignete Metallisierung zur Erstellung ohmscher Kontakte für Gate, Source und Drain aufgebracht.

Das vorgeschlagene Verfahren eignet sich besonders für die Erzeugung von Trench-MOSFETs in monokristallinem, insbesondere epitaktisch gewachsenem SiC, lässt sich jedoch prinzipiell auch für die Erzeugung derartiger MOSFETs in anderen Halbleitermaterialien wie Si oder GaN einsetzen.

### Kurze Beschreibung der Zeichnungen

Das vorgeschlagene Verfahren wird nachfolgend anhand eines Ausführungsbeispiels in Verbindung mit den Zeichnungen nochmals näher erläutert. Hierbei zeigen:
- Fig. 1.1-1.9: verschiedene Herstellungsschritte zur Herstellung eines Trench-MOSFET gemäß dem vorgeschlagenen Verfahren; und
- Fig. 2: einen Vergleich der n⁺-Source-Implantation mit und ohne die thermische Oxidschicht des vorgeschlagenen Verfahrens auf Basis einer TCAD (Technology Computer-Aided Design) Prozess-Simulation.

### Wege zur Ausführung der Erfindung

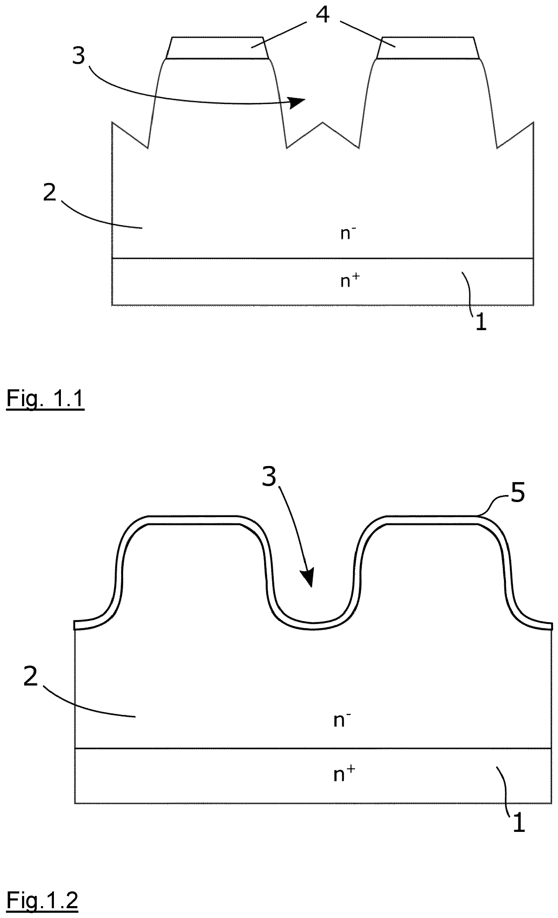

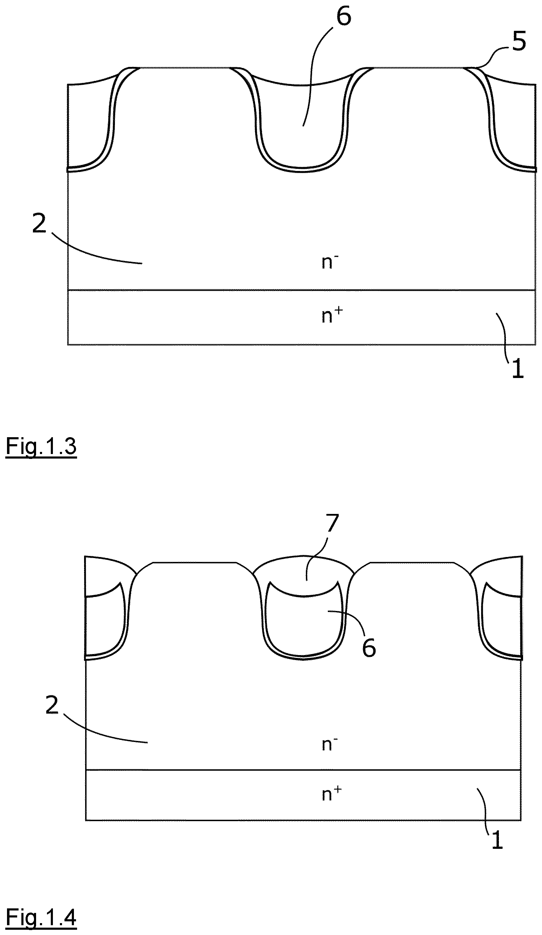

Das vorgeschlagene Verfahren wird zur Herstellung eines Trench-MOSFET in einer epitaktischen SiC-Schicht im Folgenden anhand der Figuren 1.1 - 1.9 nochmals beispielhaft erläutert. Die Herstellung des MOSFET erfolgt hierbei in einer epitaktisch gewachsenen SiC-Schicht 2 mit einer n⁻-Dotierung auf einem n⁺-Substrat 1 aus SiC. Zunächst werden in der SiC-Schicht 2 die Gräben 3 erzeugt. Hierzu wird eine Hartmaske 4 aus SiO₂ mittels PECVD (PECVD: Plasma Enhanced Chemical Vapor Deposition) mit einer Dicke von in diesem Beispiel 1000 nm aufgebracht. Die Gräben 3 werden dann durch Trockenätzen in der SiC-Schicht 2 erzeugt, wie dies in Figur 1.1 angedeutet ist. Durch eine Hochtemperaturbehandlung werden die Kanten der Gräben 3 geglättet. Anschließend wird ganzflächig eine dünne Streuoxid-Schicht 5 abgeschieden (vgl. Figur 1.2), das Gitterführungseffekte (Channeling) bei den späteren Implantationsschritten verhindern soll. Danach wird eine Planarisierungsschicht ausreichender Dicke aus Polysilizium 6 abgeschieden, durch die die Gräben 3 zumindest teilweise aufgefüllt werden. Die Abscheidung erfolgt hierbei ganzflächig, also auch auf den MESA-Strukturen zwischen den Gräben 3. Die Oberfläche wird anschließend mit einem Trockenätzprozess planarisiert, wobei das Polysilizium von den MESA-Strukturen entfernt wird, wie dies in Figur 1.3 zu erkennen ist. Der Trockenätzprozess verhält sich selektiv zu der unter der Polysiliziumschicht befindlichen Oxidschicht (Streuoxid 5) und endet, wenn die Oxidoberfläche der MESA-Strukturen von der Polysiliziumschicht freigelegt ist. Das sich in den Gräben 3 befindliche Polysilizium 6 bleibt hierbei erhalten.

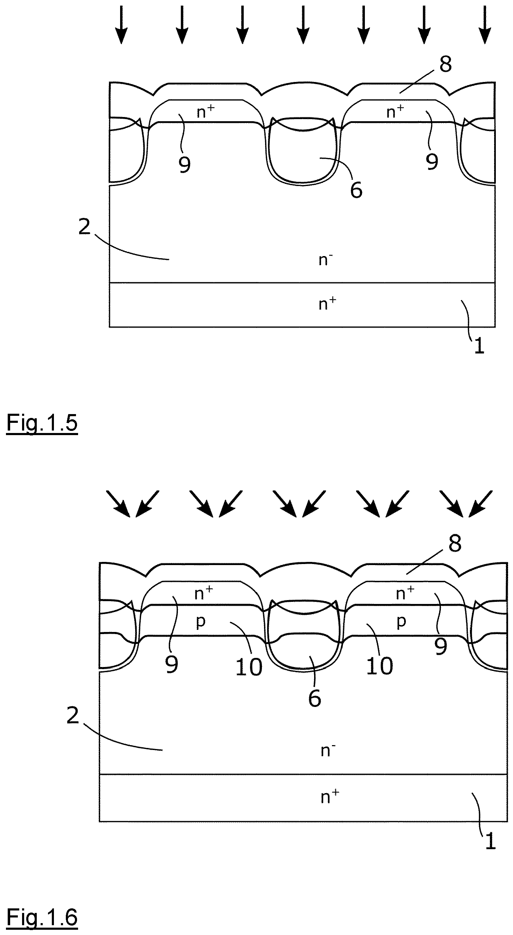

Im nächsten Prozessschritt erfolgt eine thermische Oxidation des Polysiliziums 6 in den Gräben, um eine ausreichend dicke thermische SiO₂-Schicht 7 auf dem Polysilizium 6 zu erzeugen. Dies ist in Figur 1.4 dargestellt und kann bspw. durch eine feuchte Oxidation bei 950°C erfolgen. Die für die feuchte Oxidation gewählte relativ niedrige Temperatur < 1000°C hat den Vorteil, dass Siliziumcarbid bei dieser Temperatur kaum oxidiert wird (nur wenige nm), Polysilizium dagegen sehr viel schneller bzw. stärker. Diese thermische SiO₂-Schicht 7 wird so dick erzeugt, dass sie eine zuverlässige Implantationsmaskierung für die späteren Implantationsschritte zur Erzeugung der n⁺-Source- und p-Wanne-Gebiete bildet. Durch diese Schicht wird das Risiko eines sich ausbildenden leitfähigen Kanals an den Grabenseitenwänden eliminiert. Im vorliegenden Beispiel wird anschließend noch eine dünne Streuoxid-Schicht 8 ganzflächig abgeschieden, um durch den vorangegangenen Trockenätzprozess ggf. entferntes Streuoxid zu ersetzen. Es folgt zunächst ein Implantationsschritt zur Erzeugung der n⁺-Source-Gebiete 9 (Figur 1.5) und anschließend ein Implantationsschritt zur Erzeugung der p-Wanne-Gebiete 10 (Figur 1.6). Die Ionenimplantation zur Erzeugung der p-Wanne-Gebiete 10 erfolgt in diesem Beispiel unter Kippung des Substrates um einen Winkel von +7° und von -7°, um wiederum mögliche Gitterführungseffekte (Channeling) zu vermeiden.

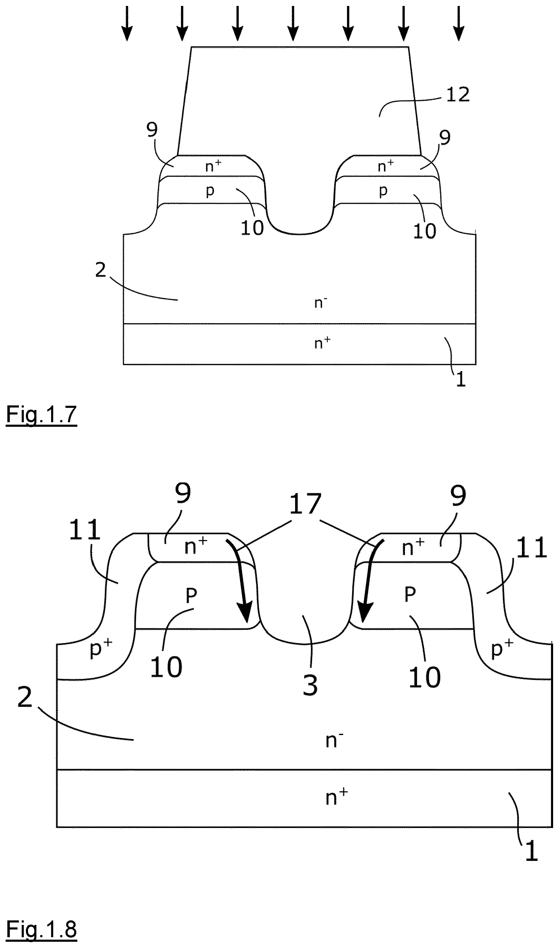

Im vorliegenden Beispiel wurde erkannt, dass die Verwendung eines üblichen unidirektionalen Verkippungswinkels von +7° zu asymmetrischen Implantationsgebieten führt. Eine zweimalige Implantation, einmal bei +7° und einmal bei -7° mit jeweils halber Dosis, ist relativ aufwändig. Da sich aus Simulationen für die Erzeugung der n+-Source-Gebiete 9 (Figur 1.5) und des p+-Shielding (p+-Gebiete 11; Figur 1.7) kein Unterschied zwischen einer Implantation mit +7° und - 7° gegenüber einer Implantation bei 0° ergab, wurde ein Verkippungswinkel von 0° für die Implantation zur Erzeugung dieser Gebiete gewählt. Dagegen ergab sich aus der Simulation für die Erzeugung der p-Wanne-Gebiete, dass durch eine zweimalige Implantation, einmal bei einem Winkel von +7° und einmal bei einem Winkel von -7°, jeweils mit halber Dosis, eine größere Kanal-Länge erreicht wurde als bei einer Implantation bei einem Winkel von 0°. Daher wurden - trotz des höheren Aufwandes - für die Implantation zur Erzeugung der p-Wanne-Gebiete 10 (Figur 1.6) Verkippungswinkel von +7° und -7° verwendet.

Das Polysilizium 6 mit der darauf befindlichen thermischen Oxidschicht 7 wird dann aus den Gräben 3 durch einen Ätzschritt entfernt und die Implantation der p⁺-Gebiete 11 mit Hilfe einer Photoresistmaske 12 durchgeführt (Figur 1.7). Figur 1.8 zeigt das Ergebnis nach Durchführung eines Temperungsschrittes. Nach dem Tempern sind aufgrund eines Diffusionseffektes die p-Wanne-Gebiete 10 in der Nähe von Grabenseitenwänden nach oben gekrümmt, wie dies aus Figur 1.8 ersichtlich ist.

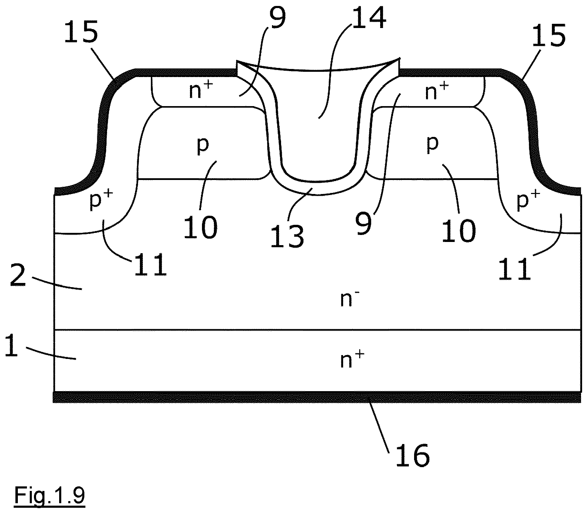

Anschließend erfolgt in bekannter Weise die Abscheidung einer Polysiliziumschicht 14 über einer vorher abgeschiedenen SiO₂-Schicht 13, die als Gate-Oxid dient, sowie die Aufbringung von Metallisierungsschichten zur Realisierung der ohmschen Kontakte, wie dies für den Source-Kontakt 15 und den Drain-Kontakt 16 in Figur 1.9 dargestellt ist.

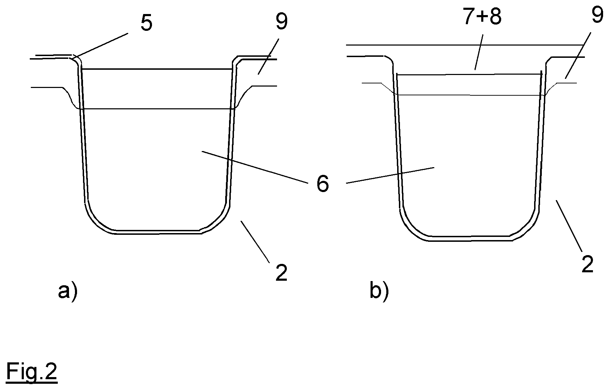

Ein wesentlicher Schritt bei dem vorgeschlagenen Herstellungsverfahren besteht in der Erzeugung der ausreichend dicken thermischen SiO₂-Schicht 7 über dem Polysilizium 6 in den Gräben 3, durch die das Risiko sich ausbildender leitfähiger Kanäle an den Grabenseitenwänden eliminiert wird. Figur 2 zeigt hierzu den Einfluss dieser thermischen Oxidschicht 7 auf den Verlauf der Dotierung der n⁺-Source-Gebiete 9 auf Basis einer KMC (Kinetic-Monte-Carlo) Simulation (hier stark vereinfacht dargestellt). Im linken Teil der Figur ist die Situation nach der Implantation ohne diese Oxidschicht im rechten Teil mit dieser Oxidschicht zu erkennen. Die unterschiedliche Krümmung der n⁺-Source-Gebiete 9 an den Seitenwänden der Gräben 3 ist deutlich zu erkennen. Über die Dicke dieser thermischen Oxidschicht 7 lässt sich somit die Dotierung im Kanalbereich 17 (vgl. Figur 1.8) des Transistors beeinflussen bzw. einstellen. Dies beeinflusst die Einsatzspannung und die Kanallänge als wesentliche Faktoren des Kanalwiderstands.

### Bezugszeichenliste

- 1: SiC-Substrat
- 2: epitaktische SiC-Schicht
- 3: Graben
- 4: SiO₂-Hartmaske
- 5: Streuoxid-Schicht (SiO₂)
- 6: Polysilizium
- 7: thermische SiO₂-Schicht
- 8: Streuoxid-Schicht (SiO₂)
- 9: n⁺-Gebiet
- 10: p-Wanne-Gebiet
- 11: p⁺-Gebiet
- 12: Photoresistmaske
- 13: SiO₂-Schicht
- 14: Polysiliziumschicht
- 15: Ohmscher Kontakt für Source
- 16: Ohmscher Kontakt für Drain
- 17: Kanal

## Patentansprüche

1. Verfahren zur Herstellung eines Trench-MOSFET mit folgenden Schritten:
- Erzeugung von Gräben (3) in einer monokristallinen Halbleiterschicht (2),
- Abscheidung einer Streuoxid-Schicht (5) und anschließend
- einer Polysiliziumschicht, so dass die Gräben (3) zumindest teilweise mit Polysilizium (6) aufgefüllt sind,
- Planarisierung der Polysiliziumschicht bis auf Oberflächen der Halbleiterschicht zwischen den Gräben (3),
- thermische Oxidation von freiliegenden Oberflächen des Polysiliziums (6) in den Gräben (3), um eine thermische SiO2-Schicht (7) über dem Polysilizium (6) in den Gräben (3) zu erzeugen, die eine Implantationsmaske für nachfolgende Implantationsschritte bildet,
- Durchführung einer ersten Ionenimplantation zur Erzeugung von Source-Gebieten (9) eines ersten Dotierungstyps,
- Durchführung einer zweiten Ionenimplantation zur Erzeugung von Wannen-Gebieten (10) eines zweiten Dotierungstyps unterhalb der Source-Gebiete (9),
- Entfernung des Polysiliziums (6) mit der thermischen SiO2-Schicht (7) aus den Gräben (3), und
- Abscheiden einer Oxidschicht (13) und anschließend einer Polysiliziumschicht (14) in den Gräben (3).

2. Verfahren nach Anspruch 1,
**dadurch gekennzeichnet,**
**dass** die thermische SiO2-Schicht (7) so dick erzeugt wird, dass ihre Oberfläche auf einem Niveau der Oberflächen der Halbleiterschicht zwischen den Gräben (3) liegt.

3. Verfahren nach Anspruch 1 oder 2,
**dadurch gekennzeichnet,**
**dass** durch die erste Ionenimplantation eine n+-Dotierung und durch die zweite Ionenimplantation eine p-Dotierung erfolgt.

4. Verfahren nach einem der Ansprüche 1 bis 3,
**dadurch gekennzeichnet,**
**dass** nach der zweiten Ionenimplantation ein Tempern erfolgt.

5. Verfahren nach einem der Ansprüche 1 bis 4,
**dadurch gekennzeichnet,**
**dass** vor der Durchführung der ersten Ionenimplantation eine ganzflächige Abscheidung einer weiteren Streuoxid-Schicht (8) erfolgt.

6. Verfahren nach einem der Ansprüche 1 bis 5,
**dadurch gekennzeichnet,**
**dass** die Entfernung der Polysiliziumschicht in den Bereichen zwischen den Gräben (3) durch Nassätzen erfolgt.

7. Verfahren nach einem der Ansprüche 1 bis 6,
**dadurch gekennzeichnet,**
**dass** vor dem Tempern noch Gebiete (11) des zweiten Dotierungstyps mit einer gegenüber den Wannen-Gebieten (10) erhöhten Dotierung über einen Maskierungsprozess und eine anschließende dritte Ionenimplantation erzeugt werden.

8. Verfahren nach einem der Ansprüche 1 bis 7 zur Herstellung eines Trench-MOSFET in einer Halbleiterschicht (2) aus Siliziumcarbid.
